(19) **Europäisches Patentamt**
**European Patent Office**
**Office européen des brevets**

(11) **EP 4 133 287 B1**

(12) **EUROPÄISCHE PATENTSCHRIFT**

(45) Veröffentlichungstag und Bekanntmachung des Hinweises auf die Patenterteilung:
**05.11.2025 Patentblatt 2025/45**

(21) Anmeldenummer: **21728440.5**

(22) Anmeldetag: **06.05.2021**

(51) Internationale Patentklassifikation (IPC):
**G01R 1/02** (2006.01) **G01R 15/20** (2006.01)

(52) Gemeinsame Patentklassifikation (CPC):
**G01R 1/02; G01R 15/207**

(86) Internationale Anmeldenummer:
**PCT/EP2021/061935**

(87) Internationale Veröffentlichungsnummer:
**WO 2021/239423 (02.12.2021 Gazette 2021/48)**

(54) **UMFANGSGLEICHVERTEILTE MAGNETFELDSENSORANORDNUNG ZUR MESSUNG EINES MAGNETISCHEN FELDES EINES LEITERS EINES ELEKTRISCHEN STROMS**

MAGNETIC FIELD SENSOR ASSEMBLY, WHICH IS EVENLY DISTRIBUTED AROUND THE CIRCUMFERENCE, FOR MEASURING A MAGNETIC FIELD OF A CONDUCTOR OF AN ELECTRIC CURRENT

ENSEMBLE CAPTEUR DE CHAMP MAGNÉTIQUE DE MESURE DE CHAMP MAGNÉTIQUE D'UN CONDUCTEUR DE COURANT ÉLECTRIQUE, UNIFORMÉMENT RÉPARTI SUR LA CIRCONFÉRENCE.

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.05.2020 DE 102020206528**

(43) Veröffentlichungstag der Anmeldung:
**15.02.2023 Patentblatt 2023/07**

(73) Patentinhaber: **Siemens Aktiengesellschaft 80333 München (DE)**

(72) Erfinder:
• **ZAPF, Florian**
**91054 Buckenhof (DE)**
• **WEISS, Roland**
**91058 Erlangen (DE)**
• **FLEISCH, Karl**
**91054 Erlangen (DE)**

(74) Vertreter: **Siemens Patent Attorneys Postfach 22 16 34 80506 München (DE)**

(56) Entgegenhaltungen:
EP-A- 3 543 715    DE-A1- 102008 030 334
DE-B3- 102015 100 924    JP-A- 2012 247 250
US-A- 5 241 263    US-A1- 2014 320 122

## Beschreibung

HINTERGRUND DER ERFINDUNG

Gebiet der Erfindung

Die vorliegende Erfindung betrifft eine Vorrichtung zur Messung eines magnetischen Feldes eines Leiters eines elektrischen Stroms, eine zugehörige Stromstärkeermittlungseinheit und ein zugehöriges Verfahren zum Ermitteln der elektrischen Stromstärke in dem elektrischen Leiter.

Beschreibung des Stands der Technik

Zur Messung von elektrischen Strömen in elektrischen Leitern werden aktuell Shunt-Widerstände, Ringkernwandler, insbesondere Kompensationsstromwandler, Rogowskispulen oder einzelne Feldsonden, insbesondere Hallsonde oder GMR-Sensor, verwendet. Zur Messung des elektrischen Stroms ohne Flusskonzentrator durch Magnetfeldsensoren ist prinzipiell sowohl ein "open-" als auch ein "closed-loop" Betrieb einzelner Magnetfeldsensoren möglich. Erste Wandler, die ohne Flusskonzentrator arbeiten, sind vor allem für Rundleiter gedacht. Die aktuellen Messverfahren haben den Nachteil einer hohen Empfindlichkeit gegenüber Leitergeometrien mit rechteckigem Querschnitt und unterschiedlichen Breiten des Leiters.

Leiter mit rechteckigem Querschnitt und teilweise sehr ausgeprägten Aspektverhältnissen kommen in der Praxis sehr häufig vor. Es sind bereits Anordnungen bekannt, bei denen mit mehreren Feldsonden das Magnetfeld um einen Leiter gemessen wird und durch Verrechnung der Einzelsignale versucht wird, die Fremdfeldempfindlichkeit zu reduzieren (z.B. EP2437072 oder DE102009054892). Häufig wurde dabei davon ausgegangen, dass das Magnetfeld des Einzelleiters zylindersymmetrisch zur Längsachse des Einzelleiters ist. Diese Voraussetzung ist jedoch nur bei einer zylindersymmetrischen Geometrie des Leiters oder in relativ großem Abstand vom Leiter erfüllt.

In vielen technischen Anlagen weicht vor allem bei Leitern, welche größere Ströme führen sollen, die Geometrie des Leiters stark von einer zylindrischen Form ab. Bei Stromschienen in Umrichtern kommen z.B. häufig Flachleiter mit rechteckigem Querschnitt zum Einsatz, da diese Leiterform zum einen bei gleicher Querschnittsfläche einen geringeren Induktivitätsbelag und deshalb eine geringere Impedanz aufweist und zum anderen - bedingt durch die größere Oberfläche - einen geringeren Wärmeübergangswiderstand an die Umgebung ermöglicht. Zudem ist eine kosteneffiziente Fertigung des Flachleiters durch Stanzen und Biegen aus einem flachen Halbzeug möglich. Die Materialstärke ist durch das Halbzeug vorgegeben und wird durch die maximale Leistung der eingesetzten Stanz- und Biegemaschinen begrenzt. Die unterschiedlichen Querschnitte zur Erreichung der nötigen Stromtragfähigkeiten werden über die Breite der gefertigten Schiene eingestellt.

Die Form des Flachleiters führt zu einer Verteilung des magnetischen Feldes, welche von der Zylindersymmetrie abweicht und erfordert einen Stromwandler mit relativ großer Bauform, wenn der Stromwandler kreisförmig realisiert wird, wie beispielsweise in Dokument US5241263.

Da in unterschiedlichen Umrichtern unterschiedlich breite Stromschienen zum Einsatz kommen, ist eine Sensoranordnung, die den Strom unabhängig von der Leiterbreite richtig misst, besonders vorteilhaft. Aufgrund der Fertigungstoleranzen bei den Magnetfeldsensoren und den Toleranzen bei weiteren elektronischen Bauteilen ist immer ein Abgleich der Stromsensoren z.B. am Ende der Fertigung notwendig. Wenn für den Abgleich ein Leiter mit einer vom Leiter am Einsatzort abweichenden Geometrie verwendet werden kann, ist das von großem Vorteil, weil ein Abgleich, der nur für spezielle Stromschienenformen "gültig" ist, mit großen logistischen Nachteilen verbunden ist, insbesondere einer stromschienenspezifischen Lagerhaltung. Dazu ist jedoch eine Sensoranordnung notwendig, die eine von der Form des Leiters weitgehend unabhängige Messung des elektrischen Stromes ermöglicht.

Die Aufgabe der Erfindung besteht darin, eine alternative Lösung zur Messung von elektrischen Strömen in elektrischen Leitern ohne Verwendung eines Flusskonzentrators anzugeben.

ZUSAMMENFASSUNG DER ERFINDUNG

Die Erfindung ergibt sich aus den Merkmalen der unabhängigen Ansprüche. Vorteilhafte Weiterbildungen und Ausgestaltungen sind Gegenstand der abhängigen Ansprüche. Ausgestaltungen, Anwendungsmöglichkeiten und Vorteile der Erfindung ergeben sich aus der nachfolgenden Beschreibung und den Zeichnungen.

Die Erfindung betrifft eine Vorrichtung zur Messung eines magnetischen Feldes eines Leiters eines elektrischen Stroms, auch als elektrischer Leiter bezeichenbar, wobei die Messung des magnetischen Feldes ohne Verwendung eines Flusskonzentrators erfolgt, aufweisend mindestens drei Magnetfeldsensoren, wobei die mindestens drei Magnetfeldsensoren auf einem Umfang einer Ellipse angeordnet sind, wobei die Ellipse kein Kreis ist, wobei die mindestens drei Magnetfeldsensoren entlang des Umfangs der Ellipse äquidistant angeordnet sind.

Der nicht verwendete Flusskonzentrator kann insbesondere als ferromagnetischer Kern ausgebildet sein.

Der Umfang der Ellipse ist dabei eine virtuelle oder gedachte Form. Äquidistant angeordnet bedeutet, dass die mindestens drei Magnetfeldsensoren, im Folgenden auch als die Magnetfeldsensoren bezeichnet, entlang des Umfangs der Ellipse in gleichen Abständen verteilt, d.h. gleichmäßig beabstandet, sind. Das bedeutet, dass die mindestens drei Magnetfeldsensoren umfangsgleichverteilt sind und zwischen den mindestens drei Magnetfeldsensoren Umfangsabschnitte gleicher Länge liegen.

Ein Aspekt der Erfindung besteht darin, den Stand der Technik dahingehend zu verbessern, eine verbesserte Anordnung der Magnetfeldsensoren zur Messung eines magnetischen Feldes eines Leiters eines elektrischen Stroms zu wählen, wobei die Messung des magnetischen Feldes ohne Verwendung eines Flusskonzentrators erfolgt.

Nach bisherigem Stand der Technik ist eine Messung des magnetischen Feldes ohne Verwendung eines Flusskonzentrators, stark von einer Anordnung der Magnetfeldsensoren abhängig. Dieses Problem wird durch die spezielle Anordnung der Erfindung überwunden.

Eine von einer kreisförmigen und/oder zylindersymmetrische Anordnung der Magnetfeldsensoren abweichende flache, elliptische Bauform spart Platz und ermöglicht gleichzeitig die einzelnen Magnetfeldsensoren gleichmäßiger aussteuern und so einen größeren Messbereich für das magnetische Feld und den elektrischen Strom, was vor allem bei Flachleitern von Vorteil ist.

Eine elliptische Bauform, die für unterschiedliche Geometrien von Leitern geeignet ist und damit auch am Ende der Fertigung auf unterschiedlichen Stromschienen abgeglichen werden kann, ist außerdem aus technischer und logistischer Hinsicht besonders günstig.

Die Vorrichtung ermöglicht eine Strommessung mit sehr geringer Abhängigkeit von einer Veränderung der Leitergeometrie. Außerdem ist eine kostengünstige und einfache Fertigung von Stromschienen durch eine Vermeidung von Schraubstellen und damit verbundenen Verlusten in den Stromschienen zum Einbringen eines zylindrischen Schienenabschnittes, insbesondere Wandlerdurchführung, möglich.

Weitere Vorteile sind, dass die Vorrichtung auch für elektrische Leiter mir geringerer Impedanz und Leiter mit geringerer Selbsterwärmung bei gleichen Verlusten verwendet werden kann, ein einfacher Abgleich der Magnetfeldsensoren möglich ist, eine einfache Inbetriebnahme der Magnetfeldsensoren möglich ist und die Vorrichtung mit der Anordnung der Magnetfeldsensoren, d.h. den angeordneten Magnetfeldsensoren, für ein breites Gerätespektrum verwendet werden kann.

Um eine elliptische Sensoranordnung zu erhalten, die möglichst robust gegen die Veränderung der Leitergeometrie nach dem Abgleich, insbesondere am Ende der Fertigung, und damit universell einsetzbar ist, werden die Magnetfeldsensoren gleichmäßig auf dem Umfang der Ellipse, d.h. mittels Umfangsgleichverteilung, verteilt.

Da es keine analytische Formel für die Berechnung der umfangsgleichverteilten Magnetfeldsensorpositionen gibt, werden diese numerisch berechnet. Dafür wird der Umfang der Ellipse in **K** Abschnitte aufgeteilt.

Durch die **K** Abschnitte ergeben sich **K** Eckpunkte. Die **K** Eckpunkte sind mit einem Laufindex **k** durchnummeriert. Die Unterteilung in **K** Eckpunkte und somit Abschnitte erfolgt zur nummerischen Berechnung der Länge des Bogensegments der Ellipse. Es wird somit mit einem K-Eck anstelle der Ellipse gerechnet. Dabei ist K größer als insbesondere 1000*N. Es werden jedoch nur **N,** also z.B. 7 Sensoren gleichmäßig auf das K-Eck verteilt. Der Wert des Laufindexes **k** [0:K] ist dabei die Nummer der jeweiligen Ecke des K-Ecks. An der Ecke mit der Nummer **k$_n$** befindet sich dann der Magnetfeldsensor mit der Nummer n.

Die k Eckpunkte besitzen in einem x-y-Koordinatensystem die Koordinaten **x$_k$** und **y$_k$.** Von den Abschnitten wird jeweils der Umfangsanteil **U$_k$** berechnet, wobei a eine längste Halbachse der Ellipse ist und b eine kürzeste Halbachse der Ellipse ist.

$$x_k = \mathrm{a} \cdot \cos\left(k \cdot \frac{360°}{K}\right)$$

$$y_k = \mathrm{b} \cdot \sin\left(k \cdot \frac{360°}{K}\right)$$

$$\mathrm{k} = 0 \dots K \in \mathbb{N}$$

Dabei gilt: **x$_0$ = x$_K$** und **y$_0$ = y$_K$** Diese "Doppelbelegung" wird für die folgende **U$_k$**-Formel benötigt.

$$U_k = \sqrt{(x_k - x_{k-1})^2 + (y_k - y_{k-1})^2}$$

$$\mathrm{k} = 1 \dots K \in \mathbb{N}$$

Der Umfang der Ellipse wird damit zu:

$$U(k) = \sum_{i=1}^{k} U_i \,.$$

Auf diese Weise wird eine eineindeutige Funktion U(k) erhalten. Der Gesamtumfang U der Ellipse entspricht U = U(k= K).

Durch Verwendung der Umkehrfunktion **k(U)** und der Folge

$$U_n = U_0 + \frac{U}{N} \cdot n \,, n = 0 \dots N - 1, \mathrm{n} \in \mathbb{N}_0$$

kann die Folge **k(U$_n$)** der k Eckpunkte mit gleichem Umfangsabstand ermittelt werden. **U$_0$** wird als Achsenabstand bezeichnet und wird im zweiten Teil der Erfindung genauer beschrieben. Die N Magnetfeldsensoren (N = Anzahl der mindestens drei Magnetfeldsensoren) können nun mit dem Umfangsabstand $\frac{U}{N}$ auf der Ellipse angeordnet werden.

In einer Weiterbildung der Erfindung weist die Ellipse eine längste Halbachse auf. Die längste Halbachse trifft an einem Ellipsenscheitelpunkt auf die Ellipse. Einer der mindestens drei Magnetfeldsensoren ist mit einem Achsenabstand zu dem Ellipsenscheitelpunkt angeordnet. Der Achsenabstand ist dabei entlang des Umfangs der Ellipse gemessen. Der Achsenabstand ist erfindungsgemäß dahingehend optimiert, eine Abweichung eines Ergebnisses der Messung des magnetischen Feldes des Leiters des elektrischen Stroms von einem realen Wert des magnetischen Feldes des Leiters des elektrischen Stroms zu minimieren.

Zusätzlich zu dem Achsenabstand des einem der mindestens drei Magnetfeldsensoren haben die weiteren Magnetfeldsensoren der mindestens drei Magnetfeldsensoren weitere Achsenabstände, da die mindestens drei Magnetfeldsensoren äquidistant angeordnet sind.

In einer weiteren Weiterbildung der Erfindung weist die Ellipse eine längste Halbachse auf. Die längste Halbachse trifft an einem Ellipsenscheitelpunkt auf die Ellipse. Einer der mindestens drei Magnetfeldsensoren ist mit einem Achsenabstand zu dem Ellipsenscheitelpunkt angeordnet. Der Achsenabstand ist dabei entlang des Umfangs der Ellipse gemessen. Außerdem ist ein Sensorabstand durch den Umfang der Ellipse geteilt durch eine Anzahl der mindestens drei Magnetfeldsensoren definiert. Das bedeutet, dass der Sensorabstand einen Abstand entlang des Umfangs der Ellipse zwischen zwei benachbarten Magnetfeldsensoren der mindestens drei Magnetfeldsensoren angibt.

Der Achsenabstand ist erfindungsgemäß:

- bei ungerader Anzahl (N) der mindestens drei Magnetfeldsensoren ein achter Teil des Sensorabstandes und
- bei gerader Anzahl (N) der mindestens drei Magnetfeldsensoren ein vierter Teil des Sensorabstandes.

Zusätzlich zu dem Achsenabstand des einem der mindestens drei Magnetfeldsensoren haben die weiteren Magnetfeldsensoren der mindestens drei Magnetfeldsensoren weitere Achsenabstände, da die mindestens drei Magnetfeldsensoren äquidistant angeordnet sind.

Wird eine Verteilung oder Anordnung der mindestens drei Magnetfeldsensoren bei einer elliptischen Sensoranordnung nach einer Umfangsgleichverteilung vorgenommen, so ergibt sich für einen ersten Magnetfeldsensor eine optimale Anfangsposition, d.h. ein optimaler Achsenabstand zu dem Ellipsenscheitelpunkt, der zu einer Minimierung eines Messfehlers, der durch eine Änderung der Breite des Leiters hervorgerufen wird, führt. Dazu muss der Achsenabstand, d.h. Umfangssegmente $U_0$ auf der Ellipse, mit Bezug auf die längste Halbachse der Ellipse oder mit Bezug auf die x-Achse des Koordinatensystems, wie folgt gewählt werden.

Achsenabstand, d.h. Umfangssegmente $U_0$ auf der Ellipse, für eine ungerade Anzahl (N) an Magnetfeldsensoren, wobei ein Index von einem der Magnetfeldsensoren $\mu \in N_0$ ist, für den ersten Magnetfeldsensor

wird $\mu$ gleich null gewählt:

$$U_0 = \frac{U \cdot (2\mu+1)}{4 \cdot 2 \cdot N}$$

Achsenabstand, d.h. Umfangssegmentes $U_0$ auf der Ellipse, für eine gerade Anzahl (N) an Magnetfeldsensoren, wobei ein Index von einem der Magnetfeldsensoren $\mu \in N_0$ ist, für den ersten Magnetfeldsensor wird $\mu$ gleich null gewählt:

$$U_0 = \frac{U(2\mu+1)}{4 \cdot N}$$

Zusätzlich zu dem Achsenabstand mit $\mu$ gleich null des einem der mindestens drei Magnetfeldsensoren haben die weiteren Magnetfeldsensoren der mindestens drei Magnetfeldsensoren weitere Achsenabstände, da die mindestens drei Magnetfeldsensoren äquidistant zueinander, entlang des Umfangs der Ellipse gemessen, angeordnet sind. Die weiteren Achsenabstände lassen sich durch $\mu$ gleich eins bis N, wobei N die Anzahl der mindestens drei Magnetfeldsensoren ist, bestimmen.

In einer weiteren Weiterbildung der Erfindung weist die Ellipse eine kürzeste Halbachse auf. Die längste Halbachse überschreitet die vierfache Länge der kürzesten Halbachse nicht. Das hat den Vorteil, dass eine Abweichung eines Ergebnisses der Messung des magnetischen Feldes von einem realen Wert des magnetischen Feldes zu minimieren. Ein experimentelles Beispiel ist in der Figurenbeschreibung dargestellt.

In einer weiteren Weiterbildung der Erfindung weisen die mindestens drei Magnetfeldsensoren jeweils eine Sensitivitätsachse auf. Die mindestens drei Magnetfeldsensoren sind für ein in Richtung der Sensitivitätsachse ausgerichtetes magnetisches Feld maximal sensitiv. Die Sensitivitätsachse ist erfindungsgemäß tangential zu der Ellipse ausgerichtet, auch als orientiert bezeichenbar. Das bedeutet, dass die Sensitivitätsachse parallel zu magnetischen Feldlinien des magnetischen Feldes verläuft. Das hat den Vorteil, dass die maximal sensitive Richtung einen maximalen Wert des magnetischen Feldes misst.

In einer weiteren Weiterbildung der Erfindung sind die mindestens drei Magnetfeldsensoren in ungerader Anzahl (N) vorhanden. Das hat den Vorteil, dass eine Abweichung eines Ergebnisses der Messung des magnetischen Feldes von einem realen Wert des magnetischen Feldes zu minimieren. Ein experimentelles Beispiel ist in der Figurenbeschreibung dargestellt.

In einer weiteren Weiterbildung der Erfindung ist die erfindungsgemäße Vorrichtung ausgebildet den Leiter des elektrischen Stroms zumindest teilweise zu umfassen. Das bedeutet, dass der Leiter innerhalb der Ellipse angeordnet ist.

Die Erfindung umfasst außerdem eine Stromstärkeermittlungseinheit, auch als Ermittlungseinheit, Messeinheit oder Stromwandler bezeichenbar, zur Ermittlung einer elektrischen Stromstärke in einem Leiter eines elektrischen Stroms. Die Stromstärkeermittlungseinheit weist eine erfindungsgemäße Vorrichtung und eine Datenverarbeitungseinheit auf, wobei die Datenverarbeitungseinheit ausgebildet ist, die elektrische Stromstärke mit, das heißt durch Einbezug von, Messergebnissen einer magnetischen Feldstärke des magnetischen Feldes der mindestens drei Magnetfeldsensoren zu ermitteln.

Die Erfindung umfasst außerdem ein Verfahren zum Ermitteln einer elektrischen Stromstärke in einem Leiter eines elektrischen Stroms durch eine erfindungsgemäße Stromstärkeermittlungseinheit. Das Verfahren weist die folgenden Schritte auf:

- Platzieren des Leiters des elektrischen Stroms in einer erfindungsgemäßen Vorrichtung,
- Ermitteln von Messergebnissen einer magnetischen Feldstärke des magnetischen Feldes durch die Vorrichtung,
- Übertragen der Messergebnisse an die Datenverarbeitungseinheit und
- Ermitteln der elektrischen Stromstärke in dem Leiter des elektrischen Stroms durch die Datenverarbeitungseinheit.

KURZE BESCHREIBUNG DER ZEICHNUNGEN

Die Besonderheiten und Vorteile der Erfindung werden aus den nachfolgenden Erläuterungen mehrerer Ausführungsbeispiele anhand der schematischen Zeichnungen ersichtlich.

Es zeigen

Fig. 1      Magnetfeldsensoren entlang des Umfangs einer Ellipse äquidistant angeordnet,

Fig. 2      Magnetfeldsensoren mit einem Achsenabstand zu dem Ellipsenscheitelpunkt angeordnet,

Fig. 3      experimentell ermittelte Messfehler bei Veränderung der Leitergeometrie,

Fig. 4      experimentell ermittelte Messfehler bei Veränderung des Halbachsenverhältnisses,

Fig. 5      experimentell ermittelte Messfehler bei einer ungeraden und einer geraden Anzahl an Magnetfeldsensoren und

Fig. 6      eine Stromstärkeermittlungseinheit zur Ermittlung einer elektrischen Stromstärke in einem Leiter eines elektrischen Stroms.

DETAILLIERTE BESCHREIBUNG DER ERFINDUNG

In allen Figuren erfolgt eine Messung des magnetischen Feldes ohne Verwendung eines Flusskonzentrators oder eine Magnetfeldsensorenanordnung ohne Flusskonzentrator gezeigt.

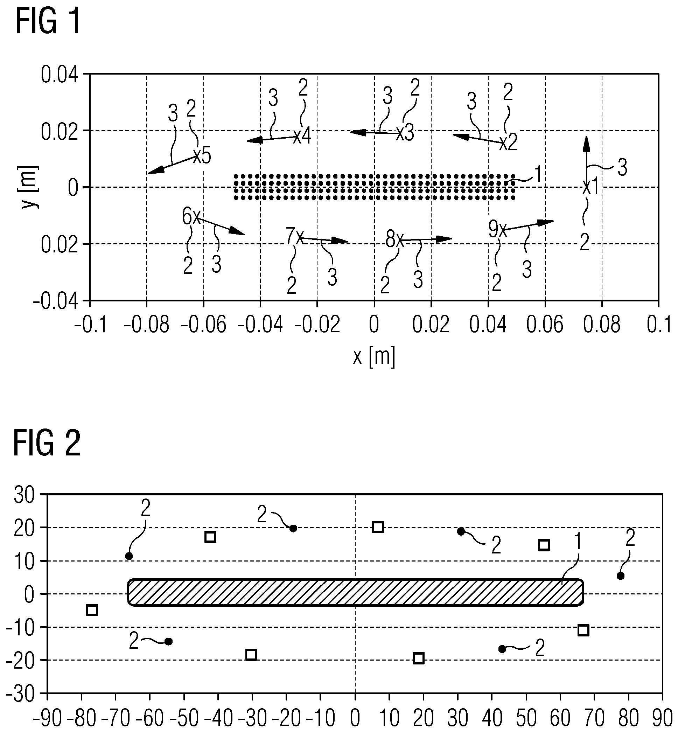

Fig. 1 zeigt neun Magnetfeldsensoren 2 (Anzahl N = 9, Magnetfeldsensoren 2 x1 bis x9) die in einem x-y-Koordinatensystem (Einheit in Metern m) entlang des Umfangs (U) einer Ellipse äquidistant, auch als umfangsgleichverteilt bezeichenbar, angeordnet sind. Dadurch ergibt sich ein Sensorabstand, auch als Umfangsabstand bezeichenbar, $\frac{U}{N} = \frac{U}{9}$ .

Die Magnetfeldsensoren 2 sind ohne Offsetwinkel von der x-Achse angeordnet. Die Ellipse weist ein Halbachsenverhältnis von 4:1 (längste Halbachse zu kürzeste Halbachse) auf.

Die Sensitivitätsachsen 3, auch als Sensitivitätsrichtungen 3 bezeichenbar, der Magnetfeldsensoren 2 ist durch Pfeile in Fig. 1 dargestellt. Als Sensitivitätsachsen 3 für die Magnetfeldsensoren 2 ist immer parallel zum Tangentenvektor der Ellipse ausgerichtet.

Die Punkte in Fig. 1 stellen elektrische Ströme dar, durch welche der elektrische Strom im rechteckigen Leiter 1 approximiert wird. Der Leiter 1 mit dem rechteckigen Querschnitt wird in den folgenden Berechnungen mit einer endlichen Anzahl an linienförmigen Strömen approximiert, die einen Abstand von 2,5 mm aufweisen.

Der Umfang der Ellipse wird in K Abschnitte aufgeteilt. Durch die K Abschnitte ergeben sich K Eckpunkte. Die K Eckpunkte sind mit einem Laufindex **k** durchnummeriert. Dabei ist zu beachten das mindestens **K >** 1000·N gelten sollte, um verlässliche Ergebnisse zu erhalten. Für die folgenden Berechnungen wurde K gleich 36000 verwendet.

Fig. 2 zeigt sieben Magnetfeldsensoren 2 (N = 7, dargestellt durch Punkte), die elliptisch mit einem Achsenabstand zu dem Ellipsenscheitelpunkt angeordnet sind. Die Skala des Koordinatensystems ist in beliebigen Einheiten gegeben. Das Halbachsenverhältnis ist 4:1 (längste Halbachse zu kürzeste Halbachse) und die Magnetfeldsensoren 2 sind umfangsgleichverteilt angeordnet.

Der Achsenabstand (Umfangssegmentes $U_0$ auf der Ellipse) für eine die ungerade Anzahl (N = 7) an Magnetfeldsensoren 2, wobei der Index $\mu$ (0 bis 6 bei N = 7 Magnetfeldsensoren, $\mu \in N_0$), für den ersten Magnetfeldsensor mit $\mu$ gleich null bestimmt ist durch:

$$U_0 = \frac{U \cdot (2\mu + 1)}{4 \cdot 2 \cdot N} = \frac{U}{4 \cdot 2 \cdot 7} = \frac{U}{56}$$

Durch den optimalen Achsenabstand $U_0$ von U/56, auch als Anfangsumfang bezeichenbar, wird eine Minimierung einer Abweichung eines Ergebnisses der Messung des magnetischen Feldes von einem realen Wert des magnetischen Feldes erreicht. Das Ergebnis ist dadurch unabhängig von der Leiterbreite. U/56 entspricht einem Winkel von 3,89° im x-y-Koordinatensystem. Die einzelnen Umfangssegmente $U_0$ bis $U_6$ sind in

Fig. 2 durch Quadrate abgegrenzt. In der Mitte jedes Umfangssegment ist ein Magnetfeldsensor 2 positioniert.

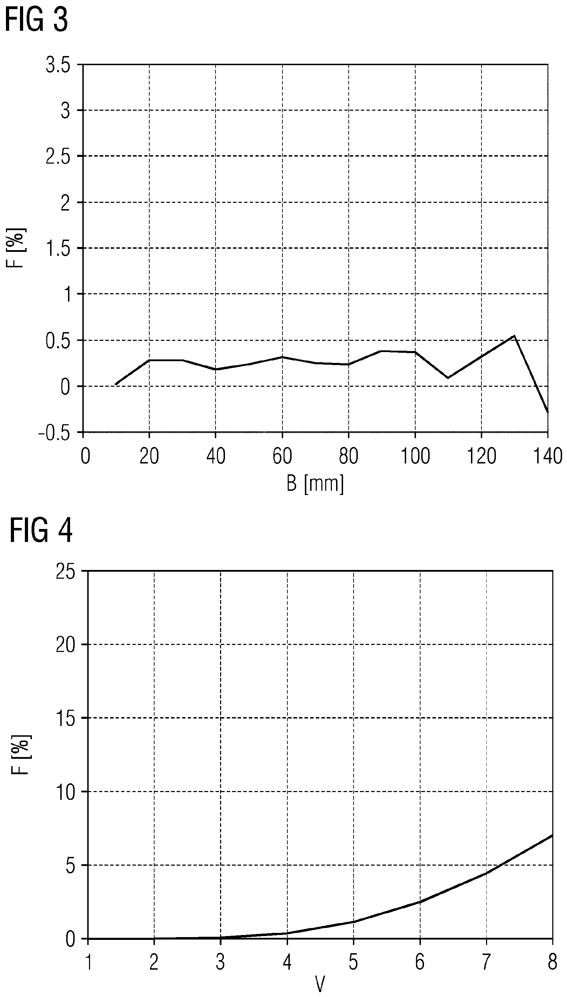

Fig. 3 zeigt experimentell ermittelte Messfehler F in Abhängigkeit der Leitergeometrie, insbesondere der Breite B eines Flachleiters bei Kalibrierung, insbesondere Abgleich, auf einen linienförmigen Leiter, wobei die Messung des magnetischen Feldes ohne Verwendung eines Flusskonzentrators erfolgt. Der Messfehler F, auch als relativer Sensitivitätsfehler F bezeichenbar, ist in Prozent % angegeben. Die Breite B des Flachleiters ist in Millimeter mm angegeben.

Durch die umfangsgleichverteilte Anordnung der Magnetfeldsensoren kann eine sehr geringe Abhängigkeit von der Leitergeometrie erreicht werden. Ohne eine Gewichtung der Magnetfeldsensoren bleibt der relative Sensitivitätsfehler F durch die Verwendung eines Flachleiters mit einer Breite B von 10 mm bis 140 mm auf der x-Achse und einer festen Höhe von 10 mm bei einer Kalibrierung mit einem linienförmigen Leiter bei unter 0,4 %. Weitere Bedingungen für die Erstellung des Graphen in Fig. 3 war ein Halbachsenverhältnis von 4:1 (längste Halbachse zu kürzeste Halbachse), eine Länge der längsten Halbachse a = 76 mm, eine Anzahl N = 9 Magnetfeldsensoren und ein Offset-Winkel, d.h. Achsabstand, von 0°. Eine Optimierung des Achsenabstandes würde den relativen Sensitivitätsfehler F weiter minimieren.

Fig. 4 zeigt experimentell ermittelte Messfehler F bei Veränderung des Halbachsenverhältnisses V (längste Halbachse zu kürzeste Halbachse) bei einer Kalibrierung mit einem linienförmigen Leiter, wobei die Messung des magnetischen Feldes ohne Verwendung eines Flusskonzentrators erfolgt. Der Messfehler F, auch als relativer Sensitivitätsfehler F bezeichenbar, bei einer Kalibrierung mit einem linienförmigen Leiter ist in Prozent % angegeben. Der relative Sensitivitätsfehler F hängt stark vom Halbachsenverhältnis V ab. Dieser Zusammenhang ist in Fig. 4 gezeigt. Es wurde eine gleichverteilte Sensoranordnung von N = 9 Magnetfeldsensoren ohne Offsetwinkel, insbesondere Achsenabstand, mit einer längsten Halbachse a = 76 mm und ein Flachleiter mit rechteckigem Querschnitt mit 100 mm x 10 mm für verschiedene Halbachsenverhältnisse V untersucht. Die Ergebnisse sind in Fig. 4 dargestellt. Ein größeres Halbachsenverhältnis V führt zu einem größerem relativer Sensitivitätsfehler F. Ein noch größeres Halbachsenverhältnis V war im Experiment nicht möglich, da die Magnetfeldsensoren nicht mehr neben dem Flachleiter platziert werden hätten können. Eine Optimierung des Achsenabstandes würde den relativen Sensitivitätsfehler F weiter minimieren.

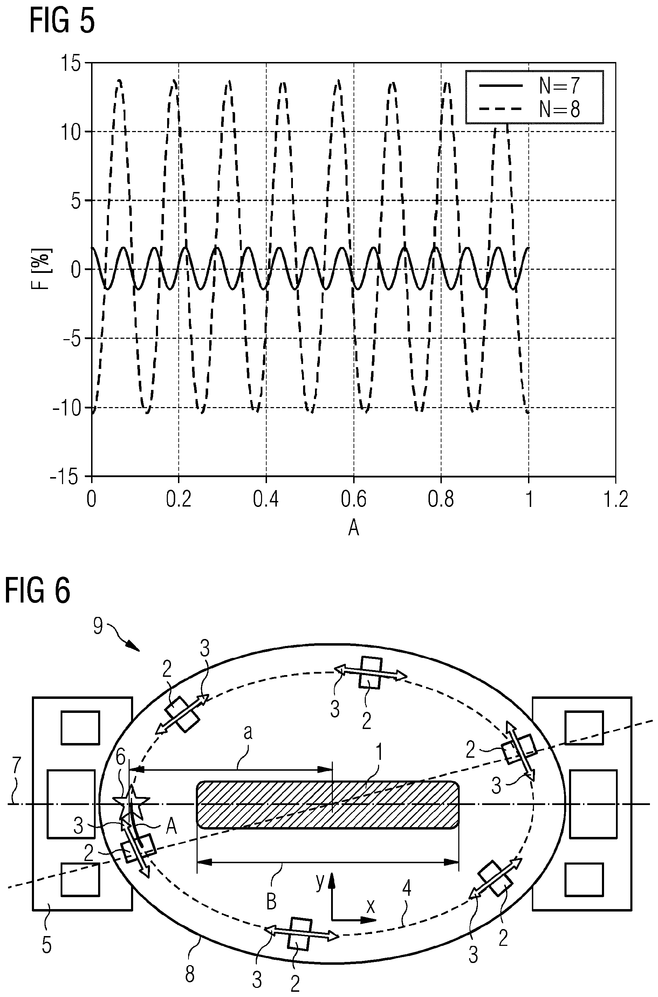

Fig. 5 zeigt experimentell ermittelte Messfehler F bei einer Kalibrierung mit einem linienförmigen Leiter bei einer ungeraden (N = 7, durchgezogener Graph) und einer geraden Anzahl (N = 8, gestrichelter Graph) an Magnetfeldsensoren in Abhängigkeit des Offset-Winkels A oder Achsenabstands A, wobei die Messung des magnetischen Feldes ohne Verwendung eines Flusskonzentrators erfolgt. Der Messfehler F, auch als relativer Sensitivitätsfehler F bezeichenbar, ist in Prozent % angegeben. Der relative Sensitivitätsfehler F ist für die Messung eines flachen Leiters mit 130 mm Breite und Umfangsgleichverteilung der Magnetfeldsensoren in Abhängigkeit des Offset-Winkels A oder Achsenabstands A dargestellt. Der flache Leiter wurde für dieses Experiment durch 130 Einzelleiter approximiert, welche gleichmäßig nebeneinander angeordnet sind. Das Sensorarray der Ellipse hat eine längste Halbachse von 80 mm und eine kürzeste Halbachse von 20 mm. Es ist in Fig. 5 zu erkennen, dass die maximalen relativen Sensitivitätsfehler F bei der Verwendung von 7 Magnetfeldsensoren (ungerade Anzahl) um ein Vielfaches kleiner sind als bei der Verwendung von 8 Magnetfeldsensoren (gerade Anzahl). Eine ungerade Anzahl an Magnetfeldsensoren ist von Vorteil. Eine Optimierung des Achsenabstandes A minimiert den relativen Sensitivitätsfehler F.

Fig. 6 zeigt eine Stromstärkeermittlungseinheit 9 zur Ermittlung einer elektrischen Stromstärke in einem Leiter 1 eines elektrischen Stroms, wobei die Messung des magnetischen Feldes ohne Verwendung eines Flusskonzentrators erfolgt. Der Leiter hat die Breite B. Die Stromstärkeermittlungseinheit 9 weist eine Vorrichtung 8 und eine Datenverarbeitungseinheit 5 auf.

Die Vorrichtung 8 ist zur Messung eines magnetischen Feldes eines Leiters 1 eines elektrischen Stroms ausgebildet, wobei die Messung des magnetischen Feldes ohne Verwendung eines Flusskonzentrators erfolgt. Die Vorrichtung 8 umfasst den Leiter 1 des elektrischen Stroms zumindest teilweise. Die Vorrichtung 8 weist sechs Magnetfeldsensoren 2 auf. Die sechs Magnetfeldsensoren sind auf einem Umfang einer Ellipse 4 angeordnet. Die Ellipse 4 ist kein Kreis. Die sechs Magnetfeldsensoren 2 sind entlang des Umfangs der Ellipse 4 äquidistant angeordnet.

Die Magnetfeldsensoren weisen jeweils eine Sensitivitätsachse 3 auf. Die Magnetfeldsensoren 2 sind für ein in Richtung der Sensitivitätsachse 3 ausgerichtetes magnetisches Feld maximal sensitiv. Die Sensitivitätsachse 3 ist tangential zu der Ellipse 4 ausgerichtet.

Die Ellipse 4 weist eine längste Halbachse a auf. Die längste Halbachse a liegt auf der Hauptsymmetrieachse 7. Die längste Halbachse a trifft an einem Ellipsenscheitelpunkt 6 auf die Ellipse 4. Der Ellipsenscheitelpunkt 6 ist in Fig. 6 durch einen Stern gekennzeichnet. Einer der mindestens drei Magnetfeldsensoren 2 ist mit einem Achsabstand A entlang der Ellipse zu dem Ellipsenscheitelpunkt 6 angeordnet. Der Achsenabstand A ist dabei entlang des Umfangs der Ellipse 4 gemessen.

Der Achsenabstand A ist dahingehend optimiert, eine Abweichung eines Ergebnisses der Messung des magnetischen Feldes des Leiters 1 von einem realen Wert des magnetischen Feldes des Leiters 1 zu minimieren, wobei die Messung des magnetischen Feldes ohne Verwendung eines Flusskonzentrators erfolgt. Das kann insbesondere dadurch erreicht werden, dass, wobei ein Sensorabstand durch den Umfang der Ellipse 4 geteilt durch eine Anzahl (N) der Magnetfeldsensoren 2 definiert ist, der Achsenabstand A:

- bei ungerader Anzahl (N) der Magnetfeldsensoren 2 ein achter Teil des Sensorabstandes ist und
- bei gerader Anzahl (N) der Magnetfeldsensoren 2 ein vierter Teil des Sensorabstandes ist.

Die Datenverarbeitungseinheit 5 ist ausgebildet, die elektrische Stromstärke mit Messergebnissen der sechs Magnetfeldsensoren 2 zu ermitteln. Die sechs Magnetfeldsensoren 2 können insbesondere eine magnetische Feldstärke des magnetischen Feldes messen.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

Bezugszeichenliste

| | |
|---|---|
| 1 | Leiters eines elektrischen Stroms |
| 2 | Magnetfeldsensor |
| 3 | Sensitivitätsachse |
| 4 | Ellipse |
| 5 | Datenverarbeitungseinheit |
| 6 | Ellipsenscheitelpunkt |
| 7 | Hauptsymmetrieachse |
| 8 | Vorrichtung |
| 9 | Stromstärkeermittlungseinheit |
| | |
| a | längste Halbachse |
| A | Achsenabstand |
| N | Anzahl der Magnetfeldsensoren 2 |

**Patentansprüche**

1. Vorrichtung (8) zur Messung eines magnetischen Feldes eines Leiters (1) eines elektrischen Stroms, wobei die Messung des magnetischen Feldes ohne Verwendung eines Flusskonzentrators erfolgt, aufweisend:

   mindestens drei Magnetfeldsensoren (2), wobei die mindestens drei Magnetfeldsensoren (2) auf einem Umfang einer Ellipse (4) angeordnet sind, wobei die Ellipse (4) kein Kreis ist, wobei die mindestens drei Magnetfeldsensoren (2) entlang des Umfangs der Ellipse (4) äquidistant angeordnet sind, wobei die Ellipse (4) eine längste Halbachse (a) aufweist, wobei die längste Halbachse (a) an einem Ellipsenscheitelpunkt (6) auf die Ellipse (4) trifft,

**dadurch gekennzeichnet, dass** einer der mindestens drei Magnetfeldsensoren (2) mit einem Achsenabstand (A) zu dem Ellipsenscheitelpunkt (6) angeordnet ist, wobei ein Sensorabstand durch den Umfang der Ellipse (4) geteilt durch eine Anzahl (N) der mindestens drei Magnetfeldsensoren (2) definiert ist, wobei der Achsenabstand (A):

   - bei ungerader Anzahl (N) der mindestens drei Magnetfeldsensoren (2) ein achter Teil des Sensorabstandes ist und
   - bei gerader Anzahl (N) der mindestens drei Magnetfeldsensoren (2) ein vierter Teil des Sensorabstandes ist.

2. Vorrichtung (8) nach Anspruch 1,

   wobei die Ellipse (4) eine kürzeste Halbachse aufweist, wobei die längste Halbachse (a) die vierfache Länge der kürzesten Halbachse nicht überschreitet.

3. Vorrichtung (8) nach einem der vorhergehenden Ansprüche,

   wobei die mindestens drei Magnetfeldsensoren (2) jeweils eine Sensitivitätsachse (3) aufweisen, wobei die mindestens drei Magnetfeldsensoren (2) für ein in Richtung der Sensitivitätsachse (3) ausgerichtetes magnetisches Feld maximal sensitiv sind, wobei die Sensitivitätsachse (3) tangential zu der Ellipse (4) ausgerichtet ist.

4. Vorrichtung (8) nach einem der vorhergehenden Ansprüche, wobei die mindestens drei Magnetfeldsensoren (2) in ungerader Anzahl (N) vorhanden sind.

5. Vorrichtung (8) nach einem der vorhergehenden Ansprüche, ausgebildet den Leiter (1) des elektrischen Stroms zumindest teilweise zu umfassen.

6. Stromstärkeermittlungseinheit (9) zur Ermittlung einer elektrischen Stromstärke in einem Leiter (1) eines elektrischen Stroms aufweisend:

   - eine Vorrichtung (8) nach einem der vorherigen Ansprüche und
   - eine Datenverarbeitungseinheit (5), wobei die Datenverarbeitungseinheit (5) ausgebildet ist, die elektrische Stromstärke mit Messergebnissen der mindestens drei Magnetfeldsensoren (2) zu ermitteln.

**7.** Verfahren zum Ermitteln einer elektrischen Stromstärke in einem Leiter (1) eines elektrischen Stroms durch eine Stromstärkeermittlungseinheit (9) nach Anspruch 6 mit den Schritten:

- Platzieren des Leiters (1) des elektrischen Stroms in einer Vorrichtung (8) nach einem der Ansprüche 1 bis 5,
- Ermitteln von Messergebnissen einer magnetischen Feldstärke des magnetischen Feldes durch die Vorrichtung (8),
- Übertragen der Messergebnisse an die Datenverarbeitungseinheit (5) und
- Ermitteln der elektrischen Stromstärke in dem Leiter (1) des elektrischen Stroms durch die Datenverarbeitungseinheit (5).

**Claims**

**1.** Apparatus (8) for measuring a magnetic field of a conductor (1) of an electric current, wherein the magnetic field is measured without using a flux concentrator, having:

at least three magnetic field sensors (2), wherein the at least three magnetic field sensors (2) are arranged on a circumference of an ellipse (4), wherein the ellipse (4) is not a circle, wherein the at least three magnetic field sensors (2) are arranged equidistantly along the circumference of the ellipse (4), wherein the ellipse (4) has a longest half-axis (a), wherein the longest half-axis (a) meets the ellipse (4) at an ellipse apex (6), **characterized in that** one of the at least three magnetic field sensors (2) is arranged at an axial spacing (A) from the ellipse apex (6), wherein a sensor spacing is defined by the circumference of the ellipse (4) divided by a number (N) of the at least three magnetic field sensors (2), wherein the axial spacing (A):

- is an eighth of the sensor spacing in the case of an odd number (N) of the at least three magnetic field sensors (2) and
- is a quarter of the sensor spacing in the case of an even number (N) of the at least three magnetic field sensors (2).

**2.** Apparatus (8) according to Claim 1,

wherein the ellipse (4) has a shortest half-axis, wherein the longest half-axis (a) does not exceed four times the length of the shortest half-axis.

**3.** Apparatus (8) according to either of the preceding claims, wherein the at least three magnetic field sensors (2) each have a sensitivity axis (3),

wherein the at least three magnetic field sensors (2) have the maximum sensitivity to a magnetic field oriented in the direction of the sensitivity axis (3), wherein the sensitivity axis (3) is oriented tangentially with respect to the ellipse (4).

**4.** Apparatus (8) according to one of the preceding claims, wherein there is an odd number (N) of the at least three magnetic field sensors (2).

**5.** Apparatus (8) according to one of the preceding claims, designed to at least partially comprise the conductor (1) of the electric current.

**6.** Current intensity determination unit (9) for determining an electric current intensity in a conductor (1) of an electric current, having:

- an apparatus (8) according to one of the preceding claims, and
- a data processing unit (5), wherein the data processing unit (5) is designed to determine the electric current intensity using measurement results from the at least three magnetic field sensors (2).

**7.** Method for determining an electric current intensity in a conductor (1) of an electric current by means of a current intensity determination unit (9) according to Claim 6, having the steps of:

- placing the conductor (1) of the electric current in an apparatus (8) according to one of Claims 1 to 5,
- determining measurement results of a magnetic field strength of the magnetic field by means of the apparatus (8),
- transmitting the measurement results to the data processing unit (5), and
- determining the electric current intensity in the conductor (1) of the electric current by means of the data processing unit (5).

**Revendications**

**1.** Dispositif (8) permettant de mesurer un champ magnétique d'un conducteur (1) d'un courant électrique, dans lequel la mesure du champ magnétique intervient sans recourir à un concentrateur de flux, comprenant :

au moins trois capteurs de champ magnétique (2),

dans lequel les au moins trois capteurs de champ magnétique (2) sont agencés sur une circonférence d'une ellipse (4), dans lequel l'ellipse (4) n'est pas un cercle,

dans lequel les au moins trois capteurs de champ magnétique (2) sont agencés de manière équidistante le long de la circonférence de l'ellipse (4),

dans lequel l'ellipse (4) présente un demi-axe (a) de plus grande longueur,

dans lequel le demi-axe (a) de plus grande longueur croise l'ellipse (4) au niveau d'un sommet d'ellipse (6),

**caractérisé en ce que**

un des au moins trois capteurs de champ magnétique (2) est agencé avec un espacement d'axe (A) par rapport au sommet d'ellipse (6),

dans lequel un espacement de capteur est défini par la circonférence de l'ellipse (4) divisée par le nombre (N) des au moins trois capteurs de champ magnétique (2),

dans lequel l'espacement d'axe (A) :

- représente la huitième partie de l'espacement de capteur en cas de nombre impair (N) des au moins trois capteurs de champ magnétique (2),

- représente la quatrième partie de l'espacement de capteur dans le cas d'un nombre pair (N) des au moins trois capteurs de champ magnétique (2).

2. Dispositif (8) selon la revendication 1, dans lequel l'ellipse (4) présente un demi-axe de plus petite longueur, dans lequel le demi-axe (a) de plus grande longueur ne dépasse pas quatre fois la longueur du demi-axe de plus petite longueur.

3. Dispositif (8) selon l'une quelconque des revendications précédentes, dans lequel les au moins trois capteurs de champ magnétique (2) présentent respectivement un axe de sensibilité (3), dans lequel les au moins trois capteurs de champ magnétique (2) sont sensibles de manière maximale à un champ magnétique orienté en direction de l'axe de sensibilité (3), dans lequel l'axe de sensibilité (3) est orienté de manière tangentielle par rapport à l'ellipse (4).

4. Dispositif (8) selon l'une quelconque des revendications précédentes, dans lequel les au moins trois capteurs de champ magnétique (2) sont présents en nombre impair (N).

5. Dispositif (8) selon l'une quelconque des revendications précédentes, conçu pour entourer au moins partiellement le conducteur (1) du courant électrique.

6. Unité de détermination d'intensité de courant (9) permettant de déterminer une intensité de courant électrique dans un conducteur (1) d'un courant électrique, comprenant :

- un dispositif (8) selon l'une quelconque des revendications précédentes et

- une unité de traitement de données (5), dans laquelle l'unité de traitement de données (5) est conçue pour déterminer l'intensité de courant électrique grâce à des résultats de mesure des au moins trois capteurs de champ magnétique (2).

7. Procédé de détermination d'une intensité de courant électrique dans un conducteur (1) d'un courant électrique grâce à une unité de détermination d'intensité de courant (9) selon la revendication 6, comprenant les étapes consistant à :

- placer le conducteur (1) du courant électrique dans un dispositif (8) selon l'une quelconque des revendications 1 à 5,

- déterminer des résultats de mesure d'une intensité de champ magnétique du champ magnétique grâce au dispositif (8),

- transmettre les résultats de mesure à l'unité de traitement des données (5) et

- déterminer l'intensité de courant électrique dans le conducteur (1) du courant électrique grâce à l'unité de traitement de données (5).

# FIG 1

# FIG 2

## FIG 3

## FIG 4

## FIG 5

## FIG 6

**EP 4 133 287 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2437072 A
- DE 102009054892
- US 5241263 A